(19) **Europäisches Patentamt / European Patent Office / Office européen des brevets**

(11) **EP 2 539 668 B1**

(12) **EUROPEAN PATENT SPECIFICATION**

(45) Date of publication and mention
of the grant of the patent:
**25.11.2015 Bulletin 2015/48**

(21) Application number: **11712685.4**

(22) Date of filing: **24.02.2011**

(51) Int Cl.:
**G06F 17/00** (2006.01) **G01B 11/06** (2006.01)
**G01B 11/24** (2006.01) **G03F 7/20** (2006.01)

(86) International application number:
**PCT/IL2011/000188**

(87) International publication number:
**WO 2011/104713 (01.09.2011 Gazette 2011/35)**

(54) **METHOD FOR MEASURNG IN PATTERNED STRUCTURES**

VERFAHREN ZUR MESSUNG BEI GEMUSTERTEN STRUKTUREN

PROCÉDÉ POUR EFFECTUER DES MESURES DANS DES STRUCTURES À MOTIFS

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **25.02.2010 US 307874 P**

(43) Date of publication of application:
**02.01.2013 Bulletin 2013/01**

(73) Proprietor: **Nova Measuring Instruments Ltd
76100 Rehovot (IL)**

(72) Inventors:
• **BRILL, Boaz**
**76302 Rehovot (IL)**
• **SHERMAN, Boris**
**76302 Rehovot (IL)**

(74) Representative: **Becker Kurig Straus
Patentanwälte
Bavariastrasse 7
80336 München (DE)**

(56) References cited:
**WO-A2-2008/096364 US-A1- 2006 068 301**

Description

FIELD OF THE INVENTION

This invention is generally in the field of semiconductor industry and relates to a technique for measuring parameters of a patterned article (e.g. semiconductor wafer).

BACKGROUND OF THE INVENTION

It is a long-standing need in the semiconductor industry to characterize the properties of a semiconductor structure. As the dimensions of semiconductor devices based on such structures are shrinking, highly sensitive metrology tools and data analysis are required for monitoring the properties of the semiconductor structure, in particular, structure in the form of a stack of patterned and un-patterned thin films.

Optical Critical Dimension (OCD) measurement technique (known also as Scatterometry) is known as being efficient for measuring parameters of patterned (periodic) structures. OCD measurements are usually performed using a fitting procedure. According to this procedure, theoretical model describing a structure under measurements is used to generate theoretical data or reference data, and the latter is iteratively compared to measured data, while varying the model parameters until the "best fit" is found. The parameters of the "best fit" model are considered as corresponding to the measured parameters.

Measured data is typically optical data, which can be analyzed to derive information regarding the geometrical parameters of patterns including thicknesses, critical dimension (CD), line spacing, line width, wall depth, wall profile, etc., as well as optical constants of materials included in the sample. Optical metrology tools used for such measurements are typically ellipsometry and/or reflectometry based tools. Reflectometry based tools typically measure changes in the magnitude of radiation returned/transmitted from/through the sample, and ellipsometry based tools typically measure changes of the polarization state of radiation after interacting with the sample. In addition or as alternative to these techniques, angular analysis of light returned (reflected and/or scattered) from a patterned (periodic) structure could be used to measure the parameters that define/characterize the structure.

WO2008096364 discloses a sample having a patterned area and a method for use in controlling a pattern parameter. The sample comprises at least one test structure having a patterned region similar to a pattern in the patterned area, the patterns in the patterned area and in the at least test structure being produced by the same patterning process. The at least one test structure comprises at least one pattern parameter of a predetermined value intentionally increased above a natural value of said certain parameter induced by a patterning process. By this, the natural value of the parameter induced by the patterning process can be determined.

US2006068301 discloses based on adjustment information on the adjustment unit under predetermined exposure conditions and information on the corresponding image-forming performance of the projection optical system: pattern correction information, information on a permissible range of the image-forming performance, and the like, a calculation step and a setting step are repeatedly performed in the case an image-forming performance in at least one exposure apparatus is outside the permissible range under the target exposure conditions until the image-forming performance in all the exposure apparatus is within the permissible range. In the calculation step, an appropriate adjustment amount under target exposure conditions whose pattern is corrected is calculated for each exposure apparatus, and in the setting step, the correction information is set according to a predetermined criterion based on the image forming performance outside the permissible range, and when the image-forming performance in all the exposure apparatus is within the permissible range, the correction information that has been set is decided as the pattern correction information

GENERAL DESCRIPTION

There is a need in the art in facilitating measurements (e.g. optical measurements) of parameters of a patterned structure.

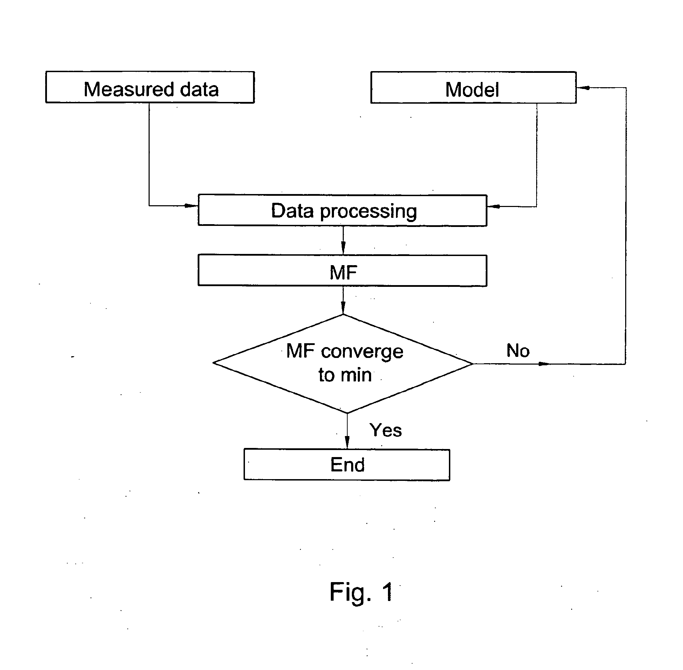

The above-described conventional approach generally consists of comparison between the theoretical and measured data. This is shown schematically in Fig. 1. Theoretical data is based on one or more optical models, each based on various combinations of multiple parameters. The parameters taken into account in the model are typically of two types, one associated with the structure and the other associated with the measurement technique. A certain function (e.g. merit function) is typically used for comparing the theoretical and measured data, and a number (value) of the merit function itself or its derivatives is defined as a parameter corresponding to a desired degree of fit. The merit function is generally a function that gets two data pieces, theoretical and measured, as input (e.g. spectral signatures) and results with a single number that is a measure of a "distance" between the two input signatures. For example, a merit function $MF(x)$ for spectra including $N$ wavelengths $\lambda_i$, may be in the form:

$$MF(x) = \frac{1}{N}\sum_{i=1}^{N}\big(I_t(\lambda_i) - I_m(\lambda_i)\big)^2 \qquad\qquad (1)$$

wherein $I_t$, and $I_m$ are theoretical and measured optical signatures (e.g. intensities), If the comparison stage does not provide a desired result, model parameters of the theoretical data are varied, thus varying the theoretical input data, and comparison is repeated until desired degree of fit (e.g. convergence to minimal value of the merit function) is obtained. It is often the case that one or more parameters of the structure have no effect or a very weak effect on the measured signal. In this case, such a parameter is kept fixed in the model to avoid instability of the model especially because of weakly affecting parameters. As for randomly varying or unknown parameters, they are usually not included in the model at all (un-modeled parameters). These and other factors reduce the accuracy of the measurements. In a typical scatterometry-based application, the challenge is to provide reliable information for process control taking into account concurrent variation of a large number of parameters, including those dependent on one another and not. Often the sensitivity of the measurement to some of the parameters is not sufficient to verify accurate measurement and the results are noisy and do not correspond to realist process behavior. The invention is thus based on the understanding of the fact that a patterned structure such a semiconductor wafer has many measurement sites and some generic understanding of the process behavior should preferably be used in order to direct and stabilize the fitting process. This would reduce uncertainty of the end results, allow to vary (float) larger number of parameters, and to enhance user trust in reported results.

According to one broad aspect of the invention, there is provided a method for use in measurement of at least one parameter of a patterned semiconductor structure as defined by the appended claims.

**BRIEF DESCRIPTION OF THE DRAWINGS**

In order to understand the invention and to see how it may be carried out in practice, embodiments will now be described, by way of non-limiting example only, with reference to the accompanying drawings, in which:

Fig. 1 is a schematic illustration of the conventional approach for measurements of parameters of a patterned structure;

Fig. 2 is a block diagram of a measurement system for measurements in patterned structures;

Fig. 3 illustrates a flow diagram of the main steps in a method for measurements in patterned structures;

Fig. 4A is a flow chart of a specific but not limited example of the method of Fig. 3; and

Fig. 4B is a flow chart of another specific but not limited example of the method of Fig. 3.

**DETAILED DESCRIPTION OF EMBODIMENTS**

Fig. 1 illustrates the general principles of the conventional approach for measurements of certain parameters based on data fitting.

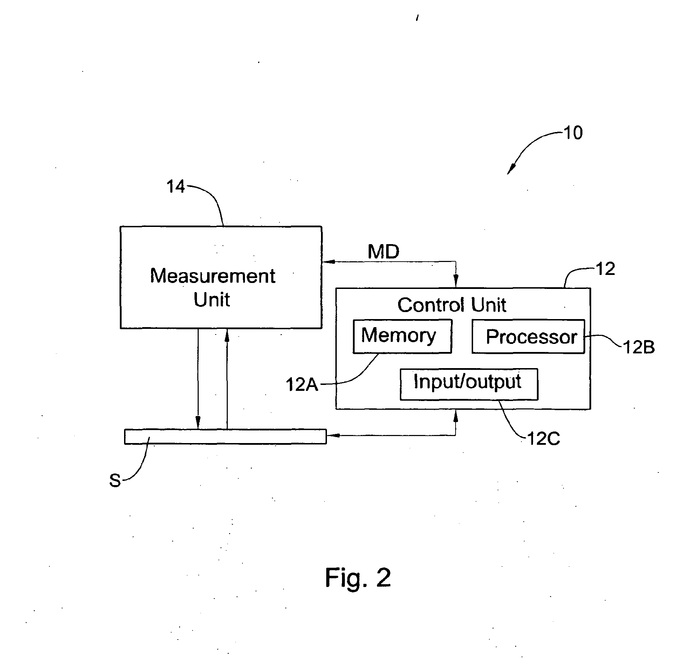

Reference is made to Fig. 2 illustrating, by way of a block diagram, a measurement system 10 configured and operable for carrying out the invention for measuring the parameters of a patterned structure **S**, e.g. that of a wafer. The system **10** includes a control unit **12** configured for processing and analyzing measured data (collected online or offline) and generating output data indicative of one or more desired parameters of the structure. The control unit **12** is generally a computer system (formed by one or more computer utilities) and includes *inter alia* a memory utility **12A**, and a processor utility **12B**; and typically also includes data input and output utilities **12C**.

The control unit **12** receives measured data **MD** either from a measurement unit **14** (via wires or wireless signal transmission, as the case may be, via appropriate data receiver) or from an external data storage into which data has been previously transferred from the measurement unit. Thus, generally measurement unit 14 constitutes one or more sources of measured data. The measurement unit may be of any suitable type, e.g. optical in case of OCD measurements. The construction and operation of the measurement unit does not part of the invention, and therefore need not be described in details, except to note the following. The optical measurement unit may utilize scatterometry-based measurements scheme, e.g. normal or oblique incidence, spectral or angle based, etc., or combinations thereof. The example of a measurement unit suitable to use the present invention, is disclosed in U.S. Pat. No. 6,657,736 assigned to the assignee of the present application. This document is therefore incorporated herein by reference with respect to the specific example of scatterometry-based optical measurement system. Although the invention is exemplified below as being associated with optical measurement unit, it should be understood that the invention is not limited to this specific application. It should also be noted that measured data may be provided from more than one measurement units, which may be similar or different in the type of measurements (optical, electrical, acoustic, etc.).

The memory utility **12A** serves for storing (permanently or temporarily) theoretical data based on certain models and/or multiple sets of model parameters, used in fitting procedure. According to the invention, the fitting procedure is optimized using data certain penalty function, which may be previously stored in the system or may be derived from measured data. Generally, the penalty function is associated with certain knowledge (data) about one or more global parameters/conditions of the structure under measurements. It should be understood that such knowledge does not necessarily mean that value(s) of certain parameter(s) is/are known prior to actual measurements, but that the behavior of one or more global parameters is known or the knowledge can be updated during actual measurements. The global parameter is typically a characteristic of the structure. In this connection, it should be understood that the patterned structure to be measured includes a set of sites characterized by one or more similar parameters. The invention utilizes optimization criteria through global parameter(s) that describe expected behavior of said parameter across the set (e.g. based on the manufacturing process). Thus, the processor utility **12B** operates for determining a relation between theoretical and measured data optimized by applying a penalty function based on the global parameter(s). Then, the optimized relation is used for determining the desired parameter of the structure. This will be described more specifically further below.

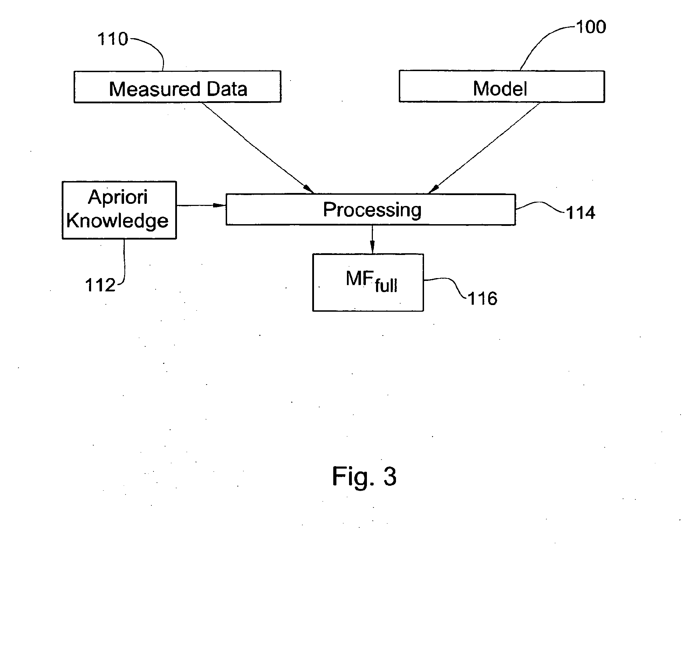

Referring to **Fig. 3**, there is illustrates a flow diagram of the main procedures of a method of the invention that can be implemented by the above-described system (i.e. the control unit). Theoretical data is provided (step **100**). This theoretical data is typically generated off-line, i.e. prior to and independent of the actual measurements on a specific structure, and presents a collection (library) of theoretical signals (signatures) each corresponding to data measurable from a certain type of structure under certain conditions (i.e. values of parameters). In case of spectrometry-based OCD measurements in wafers, these may be spectral signatures. Measured data **MD** from at least two (but preferably multiple) measurement sites on the structure **S** is provided (step **110**). Concurrently with obtaining the measured data or separately (e.g. before measurements) data indicative about one or more global parameters of the specific structure under measurements is provided (step **112**).

Theoretical data and measured data are processed (step **114**) using said data about the global parameter (provided in step **112**), defining a certain penalty function used for processing the measured data vs theoretical data resulting in an optimized merit function, $MF_{full}$ (step **116**). This merit function number, $MF_{full}$, is determined as a certain function of a local merit function, $MF_{local}$, indicative of comparison (relation) between the theoretical and measured data for a certain measurement site, and a global merit function, $MF_{global}$, corresponding to the penalty function based on the data about the global parameter(s):

$$MF_{full} = f(MF_{local}, MF_{global}) \qquad (2)$$

According to one example, the optimized merit function $MF_{full}$ can be determined as follows:

$$MF_{full} = MF_{local} + MF_{global} \qquad (3)$$

In another not limiting example:

$$MF_{full} = MF_{local} \cdot (1+G) \qquad (4)$$

wherein G is determined from global parameters known/determined for all the sites.

Then, although not specifically shown in this figure, the merit function $MF_{full}$ is analyzed to identify whether it satisfies a predetermined condition corresponding to a desired degree of fit. If not, the theoretical model is varied according to iteration procedure, until the best fit is reached (e.g. desired minimal number of the merit function). Based on the best fit result, the parameters of the corresponding model are used to characterize the measured parameters.

In some examples, the processing of the measured data may start from a standard procedure including the following: Each measurement site is fitted separately using a standard optimization process as described above with reference to Fig. 1. It should be noted that since this stage of the data processing is not expected to be final, but just a starting point for next phase, a degree of match/fit could be relatively low thus saving computation time. Then, the next stage of processing is performed starting from the "low accuracy" of the fitting procedure of each site resulting from the initial, standard stage of processing or generally starting from any point. This next stage of processing is based on the data about the global parameter(s) and is aimed at optimizing/adjusting the merit function.

For example, at least one global parameter is defined / calculated, $g_1$; $g_2$, .... $g_1$, for each of the sites in the predefined set. It should be noted that global parameters could be uniform for all of the sites or could be of different values for each or some of the sites, determined from the measurement results in some or all the sites, as known from previous optimization/iteration steps. Each site may be assigned with a modified optimized merit function, $MF_{full}$, that takes into account a penalty function expressed via $MR_{global}$ based on data indicative the selected global parameter(s). The full merit function number is higher than the regular, local merit function $MF_{local}$ penalizing for global behavior that the user wishes to suppress, see equations (3) and (4) above.

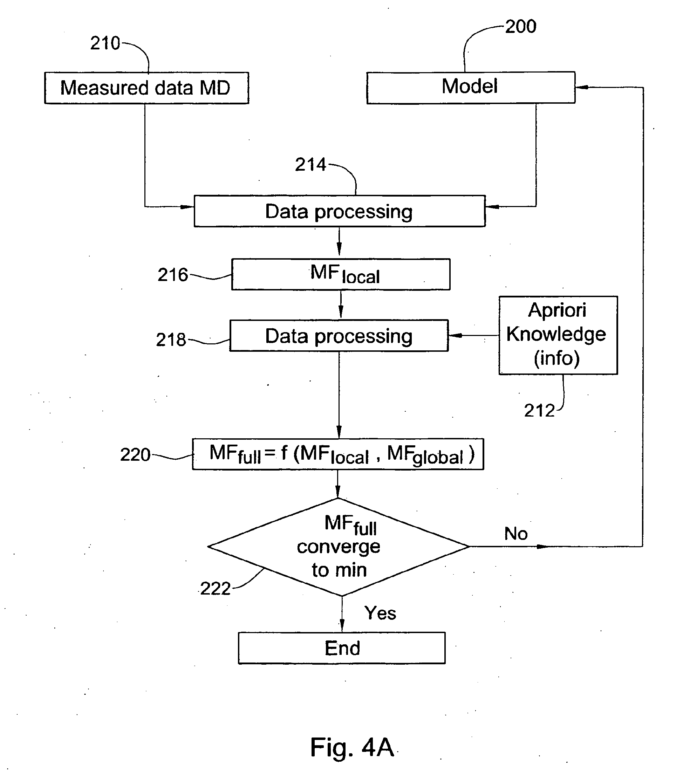

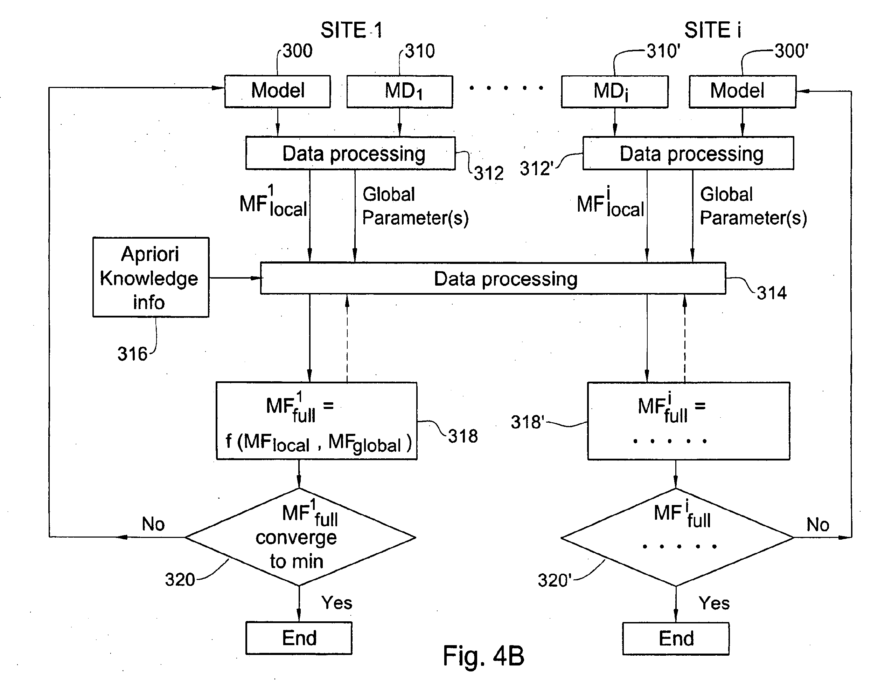

The fitting (convergence) process can proceed for each of the sites, based on the modified/optimized merit function $MF_{full}$. Stepping forward could be done either by one step or by several steps stopping according to some intermediate stopping criterion such as improving merit function to some intermediate level. The fitting procedure steps may or may not be repeated until sufficient convergence for $MF_{full}$ on all sites is obtained. This will be exemplified further below with reference to Figs. 4A and 4B.

According to some examples, a selected global parameter is associated with a certain external reference being a substantially unchangeable characteristic of the measurement process. The optimization procedure thus utilizes fitting to the external reference. Such external reference may for example be correlation, $R^2$, between the OCD measurement tool and CD-SEM. It should be understood that the invention can be used for improving either one of OCD or CD-SEM measurement, as well as any other measurement technique. Thus, $R^2$ is used as a common global parameter for optimization. In fact this optimization also optimizes, to a large degree, Total Measuring Uncertainty (TMU). Since the penalty function value, e.g. expressed by $MF_{global}$ number, should be minimized as much as possible, $MF_{global}$ can be expressed as:

$$MF_{global} = \alpha \cdot (1 - R^2)^n \qquad (5)$$

where $n < 1$ can be used to strengthen the effect for $R^2$ close to unity; $\alpha$ is a scale factor allowing to tune the relative strength of $MF_{global}$ vs. $MF_{local}$.

According to some other examples, a best fit method can be used to evaluate local error using global data as follows. Designating $X$ as the value estimated for the global parameter of interest (e.g. CD) at a specific site for a specific step in the optimization process, and $X_{ref}$ as the certain external reference value for the same site, a value $X_{fit}$ of said global parameter can be expressed via its relation with the external reference value as follows:

$$X_{fit} = a \cdot X_{ref} + b \qquad (6)$$

wherein $a$ and $b$ are correction coefficient optimizing $X_{fit}$ to be as close as possible to $X_{ref}$.

The individual differences between $X_{fit}$ value and the current value are used to determine the penalty function, e.g., merit function correction:

$$MF_{global} = \alpha \cdot ((X_{fit} - X)/dX)^2 \qquad (7)$$

where $dX$ is a fixed value having the dimensions of $X$ that can be used to scale the strength of $MF_{global}$ in the fitting/convergence process.

Thus, certain external reference of a constant value can be used either directly as a global parameter or as a factor defining the global parameter. Alternatively, a global parameter may be a varying parameter from site to site in the wafer with certain known distribution of its values in the sites. Such parameter may for example be a thickness, T, of the structure or at least an uppermost layer thereof across a set of measurement sites or a part thereof in the wafer. The data about the global parameter may be indicative of the smoothness of the behavior of this parameter, e.g. thickness. Stabilization of measurement results can thus be provided through the enhancement of the smoothness of the behavior of a given parameter across at least part of the set of measurement sites. This can for example be obtained using the following methods:

Local smooth value may be estimated for each site, e.g. by fitting N nearest neighbors (e.g. 3 points) to a certain smooth function and evaluating the median value of the function at the coordinate of the site. The difference between an estimated smooth value, $X_{smooth}$, and a corresponding value $X$ of the model parameter, divided by some relevant correction factor can be used as the penalty function, e.g. expressed by $MF_{global}$:

$$MF_{global} = \alpha \left( (X_{smooth} - X)/dX \right)^2 \qquad (8)$$

Instead of a smoothness function, or in addition thereto, a global behavior across the measurement sites in the wafer can be selected to be radial function / distribution of a certain global parameter, e.g. given as a polynomial function along the wafer radius R. In each step of the optimization procedure, the whole measured data set is fitted to said radial function and the level/degree of fitting (e.g. sum of residual squares or correlation) is used to determine penalty function and accordingly $MF_{global}$ for all the sites.

It should be noted that a set of the measurement sites may be selected such that they all share a common behavior of at least one parameter which is used during the optimization. Also preferably the sites are analyzed to select the proper set of measurements. For example, sites that for some reason have parameter behavior (e.g. fitting level) significantly different than the rest of the population are preferably filtered out (manually or automatically) from the set of measurements used in optimization of the merit function.

Optionally, but preferably, measurement recipes to each measurement site (information about the measurement site and/or measurement condition on said site) are defined and optimized by verifying correct spectral setting and reasonable convergence at each site.

The following are specific but not limiting examples of the technique for measuring in patterned structures.

Referring to Fig. 4A, there is illustrates a flow diagram of a method of one example, that can be implemented by the above-described system shown in Fig. 2. This specific but not limiting example illustrates a case when a global parameter is substantially constant for a specific measurement site, while being the same or not for different sites. Accordingly, the figure exemplifies processing of the measured data from one measurement site, while similar procedures could run independently, e.g. in parallel, for multiple sites.

When dealing with a global parameter that is constant for the measurement site, the global parameter might be related to a certain external reference. In this example, a global parameter value for each measurement point (site) is defined as a constant value provided by user, or as a user-defined relation (formula) between this parameter and other (floating) parameter(s) which have been determined previously. Such a formula may present a spatial distribution of the global parameter over the measurement site or generally over at least a portion of the patterned structure.

Theoretical data, including various models or multiple parameter sets of a certain model, is provided (step 200). This theoretical data is typically generated offline, i.e. prior to and independent of the actual measurements on a specific structure, and presents a collection (library) of theoretical signals (signatures) each corresponding to data measurable from a certain type of structure under certain conditions (i.e. values of parameters). In case of spectrometry-based OCD measurements in patterned structures such as semiconductor wafers, these may be spectral signatures. Measured data MD from a measurement site on the structure S is provided (step 210). Also provided (concurrently with obtaining the measured data or separately therefrom, e.g. before measurements) is data about one or more global parameters of the specific structure under measurements is provided (step 212). As indicated, this data may include global parameter value(s) or a function describing behavior of the global parameter related to one or more other floating parameter(s).

Theoretical data and measured data are processed (step 214) using said data about the global parameter (provided in step 212), and a relation between them is determined, being for example in the form of a so-called local merit function, $MF_{local}$ (step 216). Then, the merit function is optimized (step 218) by using said data about the global parameter(s). The optimization is actually implemented by applying a certain penalty function to the local merit function. The penalty function is based on the data about global parameter and may be expressed for example by a so-called global merit function, $MF_{global}$. A resulting optimized relation between the theoretical and measured data, termed here $MT_{full}$, is thus obtained (step 220) being a certain function of both the local merit function and the global merit function (see equation (2) above).

Then, the optimized merit function $MF_{full}$ is analyzed to identify whether it satisfies a predetermined condition corresponding to a desired degree of fit (step 222). If not, the theoretical model is varied according to iteration procedure, until the best fit is reached (e.g. desired minimal number of the merit function). Based on the best fit result, the parameters of the corresponding model are used to characterize the measured parameters for the measurement site (as described above). As indicated above, similar procedures can be performed for multiple sites.

Reference is made to Fig. 4B exemplifying a method for the cases where the global parameter is not constant, but is a so-called common global parameter which depends on multiple measurement sites, and thus might not be associated solely with an external reference. For example, such global parameter may have certain known general distribution (function) within the structure, while coefficients of the function need and can be updated based on measured data on at least some of the multiple sites. This will be exemplified further below.

As shown in the figure, theoretical data is provided (step 300), and measured data pieces are provided from i sites (steps 310 and 310'). In some examples, different sites are associated with different theoretical data. Accordingly, steps 300 and 300' in the figure correspond to provision of different theoretical data pieces.

6

Theoretical and measured data for each site are processed (steps 312 and 312'), using in this example different theoretical data, which is optional. This processing procedure results in certain local relations between the theoretical and measured data, e.g. local merit functions, $MF_{local}$ and $MF^i_{local}$ and certain values of a parameter which is or is related to the global parameter, which are determined using the respective local merit functions. The so-determined "local values" corresponding to the global parameter are processed (steps 314) based on previously provided data about one or more global parameters (step 316), e.g. the global parameter behavior (e.g. its special distribution). This processing in step 314 is aimed at determining a penalty function, or the so-called global merit function.

In this example, where the global parameter is a common one for multiple measurement sites, the penalty function is also dependent on the multiple sites. For example, the penalty function utilizes an average value of the global parameter, or the global parameter in the form of a known function (e.g. polynomial) with unknown one or more coefficients. For example, the penalty function is expressed by a certain linear function:

$$P(x,y) = ax + by + c \qquad (9)$$

where coefficients $a$, $b$, $c$ could be defined/updated from previous iteration (step 312 and 312'). The calculation might requires at least three sites (three measured spectra), or more, for example for such parameters this may be more than 10 spectra.

Similarly, parabolic function can be used (i.e. the global parameter value is defined as a result of parabolic approximation of the results of previous iteration for all measured spectra. After the 1st iteration, a set of parameter values for each measurement point is determined $P_1(x_1,y_1)$. Then, coefficients of parabolic approximation a,b,c,d,e,f and the penalty function for each measurement point (site) is determined

$$P_2(x_i, y_i) = a x^2 + b x_i + c y_i^2 + d y_i + e x_i y_i + f \qquad (10)$$

The calculation might require 6 or more spectra, e.g. more than 20 spectra.

In yet another example, the penalty function is based on smoothing of the global parameter, e.g. the common global parameter for each measurement site is defined as the median value of the results of previous iteration for three nearest measurements locations on the wafer.

Yet further example may be that the global parameter value is a result of linear dependence approximation of one or more other floating parameter(s) determined from the previous iteration (or global parameter imposes a linear constrain between the global parameter and other floating parameter(s)):

$$P_{2k} = \sum_{i \neq k} a_i \cdot P_{1i} + c \qquad (11)$$

Here, the parameters $P_{2k}$ and $P_{1i}$ may be selected to characterize respectively CD and side wall angle (SWA).

The data about behavior of the global parameter is then used, together with the global parameter value determined from the local merit function, to define the penalty function and based thereon determine the optimized relation or the so-called full merit function $MF_{full}$ (steps 318 and 318'). Then, in some examples, the fitting procedure is carried out in a standard manner (steps 320, 320') using iteration procedure based on model parameters variation. Alternatively, the fitting procedure is further optimized by optimizing the penalty function in separate iteration procedure, by step-by-step varying the model parameter(s), determining the global parameters in different sites and determining optimized penalty function, and accordingly optimizing full merit function $MF_{full}$.

It should be noted that the above two examples of Figs. 3A and 3B may be used together. For example, the penalty function optimization by a combination of the use of constant external reference (e.g. relation between a global parameter and the external reference) and common global parameter aspect (e.g. average value of the global parameter). More specifically, at the 1st iteration stage, regular data interpretation can be used as in Fig. 1, at the 2nd iteration procedure constant global parameter value is used (e.g. a relation between the OCD and CD-SEM) provided by user, and then at 3rd iteration procedure the desired parameter value is defined as average on the results of interpretation of the 2nd iteration stage.

Thus, the invention utilizes optimization criteria defined through proper selection of global parameter(s) describing expected process behavior across the set of measurement sites. Such criteria can include inter alia, for example the following: (a) smooth behavior of a given parameter across the wafer or at least a part thereof, e.g. a specific functional behavior that is expected throughout the set, e.g. smooth behavior as function of radius ("center to edge"); (b) fitting to certain external reference (e.g. CD- SEM and vice versa); (c) parameter that is expected to be uniform across the measurement set, e.g. material parameter(s).

It should be noted that in some examples, a parameter that is expected to be uniform across the whole measured data set can be considered. A sum of deviations from the average value can be used as a global MF to enhance uniformity, or the individual deviations from an average value can be used. In this connection, the following can be taken into account: If a uniform value is forced where it is not correct, an error can be reflected on other parameters as noise. Assuming a uniform value is chosen, several schemes can be used: (1) independent optimization loop; (2) allow each site to change the global value independently, however force all values to the average after each step; (3) let each measured data set converge using the global MF such that the values are similar but not identical across the data set, than force the average on all sites and run again without varying the global parameter; and (4) similar to (3) let each measured data set converge using the global MF, and then calculate the average and replace all values with it, float again from this starting position with all parameters open.

Thus, the technique of the invention utilizing global fit approach allows for achieving more consistent results over several measurement sites or on a set of measurement points (e.g., on the entire wafer) by penalizing merit function (adding penalty) with parameters' deviation from either some kind of reference point or from the average results. The relevant penalty can be weighted to match the scale of regular (local) merit function. For example, this might be implemented as follows:

$$MF'(\bar{\mathbf{x}}) = MF(\bar{\mathbf{x}}) + \sum_{m=1}^{N_p} \alpha_m \cdot (x_m - g_m)^2 \qquad (12)$$

where $\alpha_m$ is a weight factor, and external reference $g$ for $N$ global parameters can be one or more of the following:

- external absolute reference $g=x_{ref}$, e.g. provided by CD-SEM;
- fitted external reference $g=ax_{ref}+b$ (global parameter expressed via its relation with the external reference value), where coefficients $a$ and $b$ are calculated by global fit on the full data set from the previous iteration;
- average over the wafer from the previous iteration $g=<x>$;
- more complex global fitting function, depending on wafer coordinates, e.g. parabolic fit, smoothed distribution constrains, etc.

The above is a not limiting example of the parameters and optimization procedures, which does not limit the scope of the invention.

The present invention provides a novel approach for measurement of parameters of a patterned structure utilizing the general principles of the fitting procedure, but with the use of a penalty function appropriately optimizing merit function. This can be implemented by correcting a local merit function with a global merit function corresponding to the penalty function determined by taking into account some knowledge about global parameter(s) of the structure.

**Claims**

1. A method for use in measurement of at least one parameter characterizing a patterned structure of a semiconductor wafer, the method comprising:

   providing input data, said input data comprising:

   measured data including multiple measured signals corresponding to measurements on different sites of the structure;
   data indicative of theoretical signals, a relation between the theoretical and measured signals being indicative of at least one parameter characterizing the structure;

   providing a penalty function based on at least one selected global parameter characterizing at least one property of the structure, wherein an expected behavior of said global parameter for said different measurement sites is known;
   performing a fitting procedure between the theoretical and measured signals, said performing of the fitting procedure comprising using said penalty function for determining an optimized relation between the theoretical and measured signals, and
   using the optimized relation to determine said at least one parameter of the structure; and optimizing the penalty function by carrying out an iteration procedure.

2. The method of Claim 1, comprising performing a required number of iterations using the optimized relation until reaching a desired convergence of said optimized relation, and carrying out said determination of the at least one parameter of the structure.

3. The method of Claim 1 or 2, wherein the penalty function characterizes a relation between two or more correlating parameters of the structure.

4. The method of Claim 3, wherein said correlating parameters include critical dimension and side wall angle of the pattern.

5. The method of any one of Claims 1 to 4, wherein the penalty function is based on the global parameter which is substantially constant for the measurement site.

6. The method of Claim 5, wherein the global parameter is in a certain known relation with an external reference.

7. The method of Claim 6, wherein the global parameter is associated with a correlation between a first measurement process used for obtaining said measured data and a second measurement process for determining similar parameters of the structure.

8. The method of Claim 7, wherein said first and second measurement processes comprise OCD and CD-SEM measurements.

9. The method of any one of Claims 1 to 8, wherein the penalty function is based on a common global parameter having a certain distribution within at least a part of the measurement sites.

10. The method of Claim 9, wherein the penalty function is based on an average value of the global parameter.

11. The method of Claim 9, wherein the penalty function is based on smoothing of the global parameter values.

12. The method of any one of Claims 9 to 11, wherein said certain distribution is a polynomial function.

13. The method of Claim 12, wherein at least some coefficients of said polynomial function are known.

14. The method of Claim 12 or 13, comprising performing a required number of iterations using the optimized relation until reaching a desired convergence of said optimized relation, at least some coefficients of said polynomial function being determined in one or more of said initial iteration procedures.

15. The method of any one of Claims 1 to 14, wherein said measurement in the patterned structure comprises an optical measurement.

16. The method of Claim 15, wherein the measured data comprises spectral signatures.

**Patentansprüche**

1. Verfahren zur Verwendung beim Messen von mindestens einem Parameter, der eine strukturierte Struktur eines Halbleiterwafers kennzeichnet, wobei das Verfahren umfasst:

   Bereitstellen von Eingabedaten, wobei die Eingabedaten umfassen:

   Messdaten, die mehrere Messsignale umfassen, die Messungen an unterschiedlichen Orten der Struktur entsprechen;
   Daten, die auf theoretische Signale hinweisen, wobei eine Beziehung zwischen den theoretischen und den Messsignalen auf mindestens einen Parameter hinweist, der die Struktur kennzeichnet;
   Bereitstellen einer Straffunktion basierend auf mindestens einem ausgewählten globalen Parameter, der mindestens eine Eigenschaft der Struktur kennzeichnet, wobei ein erwartetes Verhalten des globalen Parameters für die unterschiedlichen Messorte bekannt ist;
Ausführen einer Anpassungsprozedur zwischen den theoretischen und den Messsignalen, wobei das Ausführen der Anpassungsprozedur das Verwenden der Straffunktion umfasst, um eine optimierten Beziehung zwischen den theoretischen und den Messsignalen zu bestimmen, und
Verwenden der optimierten Beziehung, um den mindestens einen Parameter der Struktur zu bestimmen; und Optimieren der Straffunktion durch Ausführen einer Iterationsprozedur.

**2.** Verfahren nach Anspruch 1, umfassend das Ausführen einer erforderlichen Anzahl an Iterationen unter Verwendung der optimierten Beziehung bis zum Erreichen einer gewünschten Konvergenz der optimierten Beziehung, und das Ausführen der Bestimmung des mindestens einen Parameters der Struktur.

**3.** Verfahren nach Anspruch 1 oder 2, wobei die Straffunktion eine Beziehung zwischen zwei oder mehr entsprechenden Parametern der Struktur kennzeichnet.

**4.** Verfahren nach Anspruch 3, wobei die entsprechenden Parameter kritische Dimension und Seitenwandwinkel der Struktur umfassen.

**5.** Verfahren nach irgendeinem der Ansprüche 1 bis 4, wobei die Straffunktion auf dem globalen Parameter basiert, der für den Messort im Wesentlichen konstant ist.

**6.** Verfahren nach Anspruch 5, wobei der globale Parameter in einer bestimmten bekannten Beziehung mit einer externen Bezugnahme steht.

**7.** Verfahren nach Anspruch 6, wobei der globale Parameter mit einer Korrelation zwischen einem für das Erlangen der Messdaten verwendeten ersten Messprozess und einem zweiten Messprozess für das Bestimmen von ähnlichen Parametern der Struktur verbunden ist.

**8.** Verfahren nach Anspruch 7, wobei die ersten und zweiten Messverfahren OCD- und CD-SEM-Messungen umfassen.

**9.** Verfahren nach irgendeinem der Ansprüche 1 bis 8, wobei die Straffunktion auf einem üblichen globalen Parameter mit einer bestimmten Verteilung innerhalb mindestens eines Abschnitts der Messorte basiert.

**10.** Verfahren nach Anspruch 9, wobei die Straffunktion auf einem Durchschnittswert des globalen Parameters basiert.

**11.** Verfahren nach Anspruch 9, wobei die Straffunktion auf dem Glätten der globalen Parameterwerte basiert.

**12.** Verfahren nach irgendeinem der Ansprüche 9 bis 11, wobei die bestimmte Verteilung eine Polynomfunktion ist.

**13.** Verfahren nach Anspruch 12, wobei mindestens einige Koeffizienten der Polynomfunktion bekannt sind.

**14.** Verfahren nach Anspruch 12 oder 13, umfassend das Ausführen einer erforderlichen Anzahl an Iterationen unter Verwendung der optimierten Beziehung bis zum Erreichen einer gewünschten Konvergenz der optimierten Beziehung, wobei mindestens einige Koeffizienten der Polynomfunktion in einer oder mehreren von den anfänglichen Iterationsprozeduren bestimmt werden.

**15.** Verfahren nach irgendeinem der Ansprüche 1 bis 14, wobei die Messung in der strukturierten Struktur eine optische Messung umfasst.

**16.** Verfahren nach Anspruch 15, wobei die Messdaten spektrale Signaturen umfassen.

**Revendications**

**1.** Procédé destiné à être utilisé pour mesurer au moins un paramètre caractérisant une structure à motif d'une plaquette semi-conductrice, le procédé comprenant :

la fourniture de données d'entrée, lesdites données d'entrée comprenant :

des données mesurées comprenant plusieurs signaux mesurés correspondant à des mesures sur différents sites de la structure ;

des données iridicatives de signaux théoriques, une relation entre les signaux théoriques et les signaux mesurés étant indicative d'au moins un paramètre caractérisant la structure ;

la fourniture d'une fonction de pénalité sur la base d'au moins un paramètre global sélectionné caractérisant au moins une propriété de la structure, dans lequel un comportement prévu dudit paramètre global pour lesdits différents sites de mesure est connu ;

l'exécution d'une procédure d'ajustement entre les signaux théoriques et les signaux mesurés, ladite exécution de la procédure d'ajustement comprenant l'utilisation de ladite fonction de pénalité pour déterminer une relation optimisée entre les signaux théoriques et les signaux mesurés, et l'utilisation de la relation optimisée pour déterminer ledit au point un paramètre de la structure ; et

l'optimisation de la fonction de pénalité en effectuant une procédure d'itération.

2. Procédé selon la revendication 1, comprenant l'exécution d'un nombre requis d'itérations en utilisant la relation optimisée jusqu'à ce qu'une convergence souhaitée de ladite relation optimisée soit atteinte, et l'exécution de ladite détermination de l'au moins un paramètre de la structure.

3. Procédé selon la revendication 1 ou 2, dans lequel la fonction de pénalité caractérise une relation entre deux paramètres en corrélation ou plus de la structure.

4. Procédé selon la revendication 3, dans lequel lesdits paramètres en corrélation comprennent une dimension critique et un angle de paroi latérale du motif.

5. Procédé selon l'une quelconque des revendications 1 à 4, dans lequel la fonction de pénalité est basée sur le paramètre global qui est sensiblement constant pour le site de mesure.

6. Procédé selon la revendication 5, dans lequel le paramètre global a une certaine relation connue avec une référence externe.

7. Procédé selon la revendication 6, dans lequel le paramètre global est associé à une corrélation entre un premier processus de mesure utilisé pour obtenir lesdites données mesurées et un deuxième processus de mesure pour déterminer des paramètres similaires de la structure.

8. Procédé selon la revendication 7, dans lequel lesdits premier et deuxième processus de mesure comprennent des mesures OCD et CD-SEM.

9. Procédé selon l'une quelconque des revendications 1 à 8, dans lequel la fonction de pénalité est basée sur un paramètre global commun ayant une certaine distribution dans au moins une partie des sites de mesure.

10. Procédé selon la revendication 9, dans lequel la fonction de pénalité est basée sur une valeur moyenne du paramètre global.

11. Procédé selon la revendication 9, dans lequel la fonction de pénalité est basée sur un lissage des valeurs de paramètre global.

12. Procédé selon l'une quelconque des revendications 9 à 11, dans lequel ladite distribution est une fonction polynomiale.

13. Procédé selon la revendication 12, dans lequel au moins certains coefficients de ladite fonction polynomiale sont connus.

14. Procédé selon la revendication 12 ou 13, comprenant l'exécution d'un nombre requis d'itérations en utilisant la relation optimisée jusqu'à ce qu'une convergence souhaitée de ladite relation optimisée soit atteinte, au moins certains coefficients de ladite fonction polynomiale étant déterminés dans une ou plusieurs desdites procédures d'itérations initiales.

15. Procédé selon l'une quelconque des revendications 1 à 14, dans lequel ladite mesure dans la structure à motif comprend une mesure optique.

**16.** Procédé selon la revendication 15, dans lequel les données mesurées comprennent des signatures spectrales.

Fig. 1

14

14 ⌐

Measurement
Unit

MD

12

Control Unit

Memory

Processor

12B

12A

Input/output

12C

10

S

Fig. 2

110 — Measured Data

100 — Model

Apriori Knowledge

112 —

Processing — 114

MF$_{full}$ — 116

Fig. 3

210 — **Measured data MD**

200 — **Model**

214 — **Data processing**

216 — $MF_{local}$

218 — **Data processing**

**Apriori Knowledge (info)**

212 —

220 — $MF_{full} = f\,(MF_{local}\,,\,MF_{global}\,)$

222 — $MF_{full}$ converge to min

No

Yes

**End**

## Fig. 4A

Fig. 4B

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2008096364 A
- US 2006068301 A
- US 6657736 B